# EUROPEAN PATENT APPLICATION

(11) **EP 4 593 089 A1**
(43) Date of publication of application: **30.07.2025**
(21) Application number: 23887662.7
(22) Date of filing: 19.09.2023
(51) Int. Cl.: H01L 31/05, H01L 31/18

(54) **PHOTOVOLTAIC CELL STRUCTURE, MANUFACTURING METHOD THEREFOR AND PHOTOVOLTAIC MODULE**

(30) Priority: 07.11.2022 CN 202211386844
(71) Applicant: Longi Solar Technology (Taizhou) Co., Ltd., Taizhou, Jiangsu 225300 (CN)
(72) Inventor: ZHAO, Debao, Taizhou, Jiangsu 225300 (CN); CHEN, Peng, Taizhou, Jiangsu 225300 (CN); CHEN, Jun, Taizhou, Jiangsu 225300 (CN); LI, Hua, Taizhou, Jiangsu 225300 (CN)
(74) Representative: Pfenning, Meinig & Partner mbB
(86) International application number: PCT/CN2023/119786
(87) International publication number: WO 2024/098968

(57) **Abstract**

This application discloses a photovoltaic solar cell, a manufacturing method thereof, and a photovoltaic module, . The photovoltaic solar cell structure includes: a back contact solar cell, a soldering portion, an insulating material, and a conductive material. Each of the soldering portion is at least located on a corresponding busbar included in the back contact solar cell. The insulating material covers at least a target part of each finger included in the back contact solar cell. The target part is a part in which a distance between each of the finger and a busbar having a polarity opposite to that of the finger is less than a preset distance. The conductive material is formed on each of the soldering portion, and a height of a top of the conductive material is greater than or equal to a height of a top of the insulating material.

## Description

This application claims priority to Chinese Patent Application No. 202211386844.5, filed with the China National Intellectual Property Administration on November 07, 2022 and entitled "PHOTOVOLTAIC SOLAR CELL STRUCTURE, MANUFACTURING METHOD THEREOF, AND PHOTOVOLTAIC MODULE", which is incorporated herein by reference in its entirety.

### TECHNICAL FIELD

This application relates to the field of solar cell technologies, and in particular, to a photovoltaic solar cell structure, a manufacturing method thereof, and a photovoltaic module.

### BACKGROUND

A back contact solar cell is a solar cell in which emitters and metal contacts are arranged on a back surface of the solar cell and whose front surface is not blocked by any metal electrode. Compared with a solar cell whose front surface is blocked by a metal electrode, the back contact solar cell has a higher short-circuit current and photoelectric conversion efficiency, and is one of existing technical directions for realizing efficient crystalline silicon solar cells.

However, after at least two existing back contact solar cells are connected in series to form a photovoltaic solar cell string, operation performance of the photovoltaic solar cell string is poor.

### SUMMARY

An objective of this application is to provide a photovoltaic solar cell structure, a manufacturing method thereof, and a photovoltaic module, to prevent an exception of pseudo soldering in a process of connecting at least two back contact solar cells in series to form a photovoltaic solar cell string, and ensure high operation performance of the photovoltaic solar cell string.

According to a first aspect, this application provides a photovoltaic solar cell structure. The photovoltaic solar cell structure includes: a back contact solar cell, a soldering portion, an insulating material, and a conductive material. Each of the soldering portion is at least located on a corresponding busbar included in the back contact solar cell. The insulating material covers at least a target part of each finger included in the back contact solar cell. The target part is a part in which a distance between each of the finger and a busbar having a polarity opposite to that of the finger is less than a preset distance. The conductive material is formed on each of the soldering portion, and a height of a top of the conductive material is greater than or equal to a height of a top of the insulating material.

When the foregoing technical solution is used, each of the soldering portion is at least located on a corresponding busbar included in the back contact solar cell, so that during a soldering process, the busbar is connected to a corresponding intra-string interconnection member. In addition, the insulating material included in the photovoltaic solar cell structure covers at least a target part of each finger included in the back contact solar cell, and the target part is a part in which a distance between each of the finger and a busbar having a polarity opposite to that of the finger is less than a preset distance. Based on this, because a polarity of the soldering portion and the intra-string interconnection member that are connected to each busbar is the same as a polarity of the busbar, when the insulating material covers at least a part of each finger close to the busbar having a polarity opposite to that of the finger, the intra-string interconnection member can be prevented from overlapping with a finger having a polarity opposite to that of the intra-string interconnection member and forming a short-circuit during actual soldering due to offset of a placement position of the intra-string interconnection member, so that a requirement on precision of the placement position of the intra-string interconnection member during soldering can be reduced, and difficulty in forming the photovoltaic solar cell string can be reduced. Secondly, a working environment of a photovoltaic solar cell structure is usually outdoors, and the outdoor environment is variable, which has an impact on structural stability of the photovoltaic solar cell structure. Based on this, the insulating material is formed at least on the target position of the finger, and under protection of the insulating material, a risk that the finger breaks can be effectively reduced, and the structural stability of the photovoltaic solar cell structure can be improved.

Moreover, the conductive material included in the photovoltaic solar cell structure is formed on each of the soldering portion, and a height of a top of the conductive material is greater than or equal to a height of a top of the insulating material. In this case, the intra-string interconnection member may be in contact with a corresponding soldering portion through the conductive material, to prevent pseudo soldering, and ensure that all carriers generated during operation of each back contact solar cell can be collected by a corresponding intra-string interconnection member, further ensuring high operation performance of a photovoltaic solar cell string including the photovoltaic solar cell structure. In addition, when the insulating material is formed to enable the soldering portion to be in contact with a corresponding intra-string interconnection member, a forming thickness of the insulating material also does not need to be reduced to ensure that the insulating material has insulation performance, so that it is ensured that the intra-string interconnection member can be isolated from the finger having a polarity opposite to that of the intra-string interconnection member by using the insulating material, thereby improving high electrical stability of the photovoltaic solar cell string including the photovoltaic solar cell structure.

In a possible implementation, a range of the preset distance is from 1.5 mm to 18 mm. In this case, a size of the preset distance is moderate, to prevent a case in which a range in which the insulating material covers the finger is also small because the preset distance is small, and consequently, a placement position of the intra-string interconnection member needs to be strictly required, so that the intra-string interconnection member can be prevented from overlapping the finger having a polarity opposite to that of the intra-string interconnection member and forming a short-circuit. In this way, soldering difficulty is reduced. In addition, it is prevented that a range in which the insulating material covers the finger is also large because the preset distance is large, and consequently, an amount of the insulating materials is increased. In this way, manufacturing costs of the photovoltaic solar cell structure are reduced.

In a possible implementation, a height of the insulating material ranges from 10 µm to 80 µm. In this case, the height of the insulating material is moderate, so that it can be avoided that the insulating material has poor insulation performance because of a small height of the insulating material, and consequently, it is difficult to separate the intra-string interconnection member from the finger having a polarity opposite to that of the intra-string interconnection member by using the insulating material. In this way, high operation performance of the photovoltaic solar cell string including the photovoltaic solar cell structure is further ensured. In addition, it is also prevented that an amount of the insulating materials is increased because the height of the insulating material is large. In this way, manufacturing costs of the photovoltaic solar cell structure are reduced.

In a possible implementation, a shape of the conductive material formed on each of the soldering portion is a cube, an elliptic cylinder, or a cylinder. In this case, there are a plurality of optional solutions for a shape of the conductive material formed on each of the soldering portion. An appropriate shape of the conductive material formed on each of the soldering portion may be selected according to a requirement such as a cross-section shape of the soldering portion in an actual application scenario, to improve applicability of the photovoltaic solar cell structure provided in this application to different application scenarios.

In a possible implementation, a shape of the conductive material formed on each of the soldering portion is a cube. A length of the cube ranges from 1 mm to 2 mm, a width of the cube ranges from 1 mm to 2 mm, and a height of the cube ranges from 0.1 mm to 1 mm.

When the foregoing technical solution is used, when the shape of the conductive material formed on each of the soldering portion is the cube, the length, the width, and the height of the cube are all values in the corresponding ranges, so that it is convenient to set, based on a difference between the height of the top of the insulating material and a height of a top of a corresponding soldering portion, a specification of the conductive material formed on each of the soldering portion, to ensure that the height of the top of the conductive material can be greater than or equal to the height of the top of the insulating material. In addition, the length, the width, and the height of the cube are all values in the corresponding ranges, to avoid strictly requiring manufacturing precision of a manufacturing device for forming the conductive material to form the cube of the fixed specification, and to reduce manufacturing difficulty of the photovoltaic solar cell structure and reduce investments in the manufacturing device.

In a possible implementation, a positive electrode and a negative electrode included in the back contact solar cell each include a plurality of busbars and a plurality of fingers. The busbars included in the positive electrode and the busbars included in the negative electrode extend along a first direction and are alternately spaced along a second direction. The first direction is different from the second direction. The fingers included in the positive electrode and the fingers included in the negative electrode extend along the second direction and are alternately spaced along the first direction. Each of the fingers is connected to a busbar having the same polarity as that of the finger. Each of the fingers includes a plurality of finger sections distributed at intervals along the second direction, and a gap between two adjacent finger sections in a same finger is used for separating the finger from a busbar having a polarity opposite to that of the finger.

In a possible implementation, the insulating material covers two sides along the second direction of each of the busbar. In this case, when a placement position of the intra-string interconnection member is offset relative to a corresponding busbar along the second direction, existence of the insulating material can prevent the intra-string interconnection member from overlapping with a finger section having a polarity opposite to that of the intra-string interconnection member and forming a short-circuit during actual soldering.

In a possible implementation, a vertical distance between each of the finger sections and an adjacent busbar having a polarity opposite to that of the finger section is greater than 0 and less than or equal to 5 mm. In this case, a value of the vertical distance is moderate, to prevent connection and a short-circuit between the busbar and a finger section having a polarity opposite to that of the busbar because the vertical distance is small, thereby ensuring high electrical stability of the photovoltaic solar cell structure. In addition, a low carrier collection capability of each finger section caused by a small length of the finger section due to a large vertical distance can also be prevented, to ensure that carriers generated by a back contact solar cell after absorbing photons can be collected by and exported from a corresponding finger section in time, thereby improving photoelectric conversion efficiency of the photovoltaic solar cell structure.

In a possible implementation, the busbars and the fingers are located on a back surface of a solar cell body included in the back contact solar cell. A vertical distance between each of the soldering portion and the solar cell body ranges from 1 mm to 15 mm. In this case, the vertical distance between each of the soldering portion and the solar cell body is moderate, to prevent the back contact solar cell from being greatly affected by a soldering stress because a vertical distance between the intra-string interconnection member and the solar cell body is small during soldering due to the small vertical distance, thereby ensuring that the back contact solar cell still has good structural stability and electrical operating performance after the photovoltaic solar cell string is formed. In addition, this can also prevent a long carrier transmission path caused by a large vertical distance between the intra-string interconnection member and the solar cell body after the photovoltaic solar cell string is formed through soldering because the vertical distance is large, thereby reducing a carrier transmission resistance, and further improving electrical performance of a photovoltaic module including the photovoltaic solar cell structure.

In a possible implementation, the insulating material is an insulating adhesive.

In a possible implementation, the conductive material is at least one of a conductive adhesive, tin, and silver.

According to a second aspect, this application further provides a photovoltaic module. The photovoltaic module includes the photovoltaic solar cell structure according to the first aspect and various implementations of the first aspect, and an intra-string interconnection member configured to connect two adjacent photovoltaic solar cell structures. A distance between each part of each intra-string interconnection member and a corresponding busbar is greater than or equal to 0 and less than the preset distance.

In a possible implementation, the photovoltaic module includes a plurality of photovoltaic solar cell structures. The plurality of the photovoltaic solar cell structures are connected in series by using the intra-string interconnection member to form at least two photovoltaic solar cell strings. The photovoltaic module further includes a bus bar and an insulating bar. The bus bar is configured to connect the at least two photovoltaic solar cell strings in parallel. The insulating bar covers at least a gap between two adjacent photovoltaic solar cell structures, and/or the insulating bar covers the bus bar.

When the foregoing technical solution is used, when the insulating bar covers at least the gap between two adjacent photovoltaic solar cell structures, the insulating bar can prevent the two adjacent photovoltaic solar cell structures from overlapping, and can also block the intra-string interconnection member between the two adjacent photovoltaic solar cell structures, thereby reducing a risk such as breaking or overlapping of the intra-string interconnection member, and improving structural stability and electrical performance of the photovoltaic module. In addition, when the insulating bar covers the bus bar, a risk that the bus bar brakes can also be reduced, and the entire photovoltaic module can be beautiful.

According to a third aspect, this application further provides a manufacturing method of a photovoltaic solar cell structure. The manufacturing method of a photovoltaic solar cell structure includes:
providing a back contact solar cell;
forming a soldering portion on at least a corresponding busbar solar cell included in the back contact solar cell;
forming an insulating material covering at least a target part of each finger included in the back contact solar cell; where the target part is a part in which a distance between each of the finger and a busbar having a polarity opposite to that of the finger is less than a preset distance; and
forming a conductive material on each of the soldering portion, where a height of a top of the conductive material is greater than or equal to a height of a top of the insulating material.

For beneficial effects of the second aspect and various implementations of the second aspect and the third aspect and various implementations of the third aspect in this application, reference may be made to the analysis of the beneficial effects of the first aspect and various implementations of the first aspect, and details are not described herein again.

The foregoing descriptions are merely an overview of the technical solutions of this application. To understand the technical means of this application more clearly, implementation can be performed according to content of the specification. Moreover, to make the foregoing and other objectives, features, and advantages of this application more comprehensible, specific implementations of this application are particularly described below.

### BRIEF DESCRIPTION OF THE DRAWINGS

To describe the technical solutions in the embodiments of this application or in existing technologies more clearly, the accompanying drawings required for describing the embodiments or existing technologies are briefly described below. Apparently, the accompanying drawings in the following descriptions show some embodiments of this application, and a person of ordinary skill in the art may still derive other drawings from these accompanying drawings without creative efforts.
FIG. 1 is a schematic structural diagram of a back surface of a back contact solar cell on which a soldering portion and an insulating material are formed on corresponding positions in related technologies;
FIG. 2 is a schematic structural longitudinal cross-sectional diagram of a back contact solar cell on which a soldering portion and an insulating material are formed on corresponding positions in related technologies;
FIG. 3 is a schematic structural diagram of a back surface of a back contact solar cell according to an embodiment of this application;
FIG. 4 is another schematic structural diagram of a back surface of a back contact solar cell according to an embodiment of this application;
FIG. 5 is still another schematic structural diagram of a back surface of a back contact solar cell according to an embodiment of this application;
FIG. 6 is a partial schematic enlarged view of a photovoltaic solar cell structure according to an embodiment of this application;
FIG. 7 is a schematic structural longitudinal cross-sectional diagram of a photovoltaic solar cell structure according to an embodiment of this application;
FIG. 8 is a partial schematic enlarged view of a photovoltaic module according to an embodiment of this application;
FIG. 9 is a schematic structural longitudinal cross-sectional diagram of a photovoltaic solar cell structure on which an intra-string interconnection member is arranged on a corresponding position according to an embodiment of this application;
FIG. 10 is a schematic structural diagram of a photovoltaic module according to an embodiment of this application; and
FIG. 11 is a partial schematic enlarged view of a photovoltaic module according to an embodiment of this application.

Reference numerals: 1: back contact solar cell, 2: solar cell body, 3: positive electrode, 4: negative electrode, 5: busbar, 6: finger, 7: finger section, 8: busbar section, 9: soldering portion, 10: insulating material, 11: conductive material, 12: intra-string interconnection member, 13: bus bar, 14: insulating bar.

### DETAILED DESCRIPTION

To make the objectives, technical solutions, and advantages of embodiments of this application clearer, the following clearly and completely describes the technical solutions in the embodiments of this application with reference to the accompanying drawings in the embodiments of this application. Apparently, the described embodiments are some of the embodiments of this application rather than all the embodiments. All other embodiments obtained by a person of ordinary skill in the art based on the embodiments of this application without creative efforts shall fall within the protection scope of this application.

The accompanying drawings show various schematic structural diagrams according to the embodiments of the present disclosure. The accompanying drawings are not drawn to scale, some details are enlarged for the purpose of clarity, and some details may be omitted. Shapes of various regions and layers shown in the drawings, and relative sizes and positional relationships between the various regions and layers are merely exemplary, and may deviate in practice due to manufacturing tolerances or technical limitations, and a person skilled in the art may additionally design regions/layers with different shapes, sizes, and relative positions according to actual requirements.

In the context of the present disclosure, when a layer/element is referred to as being "on" another layer/element, the layer/element may be directly on the another layer/element, or an intermediate layer/element may exist between the layer/element and the another layer/element. In addition, if one layer/element is "above" another layer/element in an orientation, when the orientation is turned, the layer/element may be "below" the another layer/element. To make the technical problems to be resolved by, the technical solutions, and the beneficial effects of this application clearer and more comprehensible, the following further describes this application in detail with reference to the accompanying drawings and embodiments. It should be understood that, the specific embodiments described herein are merely used for describing this application and are not used for limiting this application.

In addition, the terms "first" and "second" are used merely for the purpose of description, and shall not be construed as indicating or implying relative importance or implying a quantity of indicated technical features. Therefore, a feature defined by "first" or "second" may explicitly or implicitly include one or more features. In the descriptions of this application, "a plurality of" means two or more, unless otherwise definitely and specifically limited. "Several" means one or more, unless otherwise definitely and specifically limited.

In the descriptions of this application, it should be noted that, unless otherwise explicitly stipulated and restricted, terms "installation", "joint connection", and "connection" should be understood broadly, which, for example, may be a fixed connection, or may be a detachable connection, or an integral connection; or may be a mechanical connection, or may be an electrical connection; or may be a direct connection, or may be an indirect connection by using a medium, or may be an internal communication between two components, or may be an interactive relationship between two components. A person of ordinary skill in the art may understand the specific meanings of the foregoing terms in this application according to specific situations.

At present, solar cells are increasingly widely used as a new energy alternative solution. A photovoltaic solar cell is an apparatus converting sun's light energy into electric energy. Specifically, the solar cell generates carriers by using the photovoltaic principle, and leads the carriers out by using electrodes, thereby facilitating the effective use of the electric energy.

When a positive electrode and a negative electrode included in the solar cell are both located on a back surface of the solar cell, the solar cell is a back contact solar cell. Existing back contact solar cells include a metal wrap through (MWT) solar cell, an interdigitated back contact (IBC) solar cell, and the like. A main characteristic of the IBC solar cell is that emitters and metal contacts are all located on a back surface of the solar cell, and a front surface is not blocked by metal electrodes, so that the IBC solar cell has a higher short-circuit current Isc. In addition, the back surface of the IBC solar cell may allow a wider metal grid wire to reduce series resistance Rs, so that a fill factor FF can be improved. In addition, this solar cell without blocking on its front surface is more beautiful in addition to having high photoelectric conversion efficiency. Besides, it is easier to assemble an all-back electrode module, so that the IBC solar cell is one of existing technical directions for realizing efficient crystalline silicon solar cells.

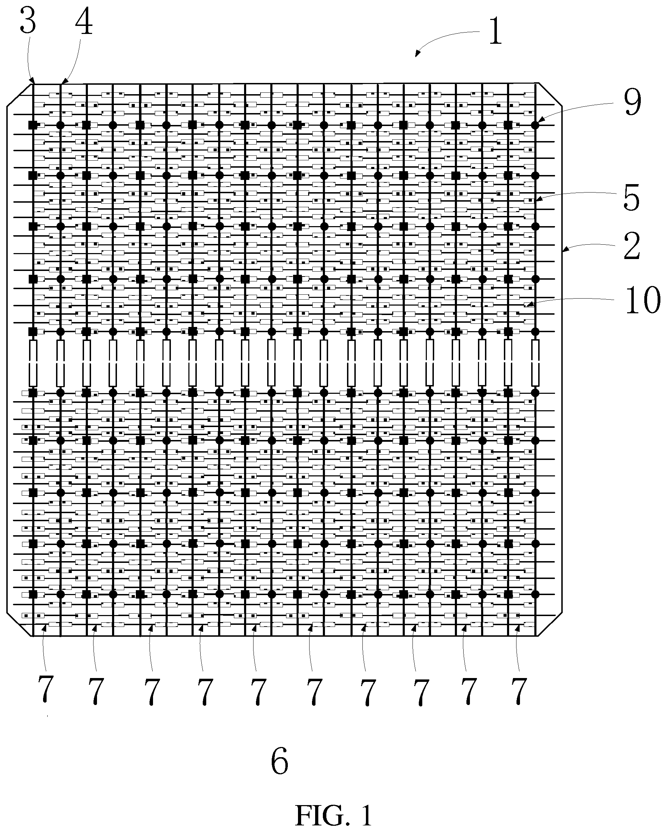

During actual application, a plurality of IBC solar cells in a photovoltaic module is usually connected in series to form a photovoltaic solar cell string by using an intra-string interconnection member such as a soldering strip, to increase an output voltage of the photovoltaic module. Specifically, in an actual manufacturing process, after the IBC cell is manufactured, as shown in FIG. 1, a soldering portion 9 soldered to the intra-string interconnection member is usually disposed on each busbar 5, and a part of each finger 6 close to a busbar 5 having a polarity opposite to that of the finger 6 is covered with an insulating material 10, to prevent an actual placement position of the intra-string interconnection member soldered to the busbar 5 from being offset, and consequently, the offset intra-string interconnection member overlaps with a finger 6 having a polarity opposite to that of the intra-string interconnection member and forms a short-circuit, thereby ensuring that the IBC cell has stable electrical performance.

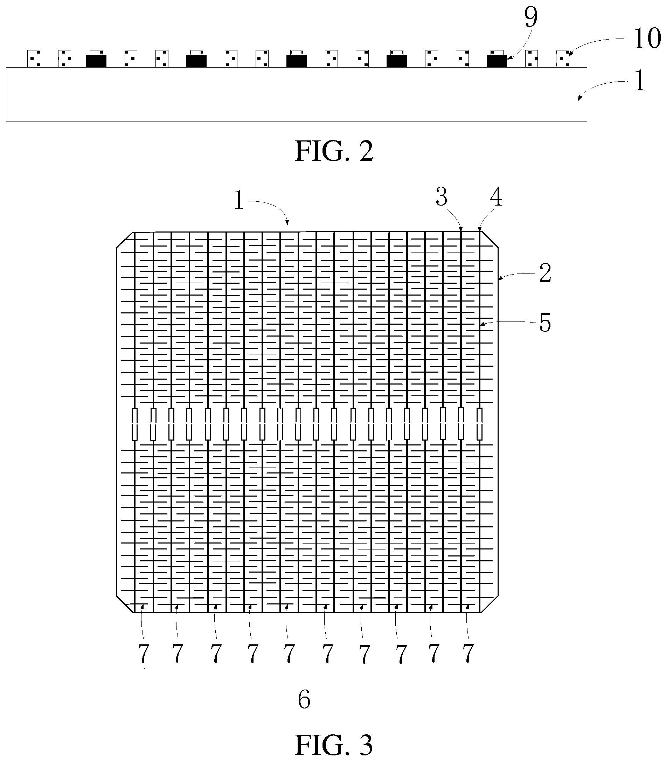

However, as shown in FIG. 2, to ensure that the intra-string interconnection member can be separated from the finger 6 having the polarity opposite to that of the intra-string interconnection member by using the insulating material 10, the insulating material 10 formed on the back surface of the IBC cell usually has a particular thickness, and consequently, a height of a top of the insulating material 10 is greater than a height of a top of the soldering portion 9. Based on this, in a process of connecting, by using the intra-string interconnection member 12, at least two IBC cells on which the soldering portion 9 and the insulating material 10 are formed in series to form a photovoltaic solar cell string, because the insulating material 10 is close to the soldering portion 9, a height difference between the insulating material 10 and the soldering portion 9 may cause the intra-string interconnection member 12 to be hardly in contact with the corresponding soldering portion 9, and further cause an exception of pseudo soldering. As a result, carriers cannot be exported by the corresponding intra-string interconnection member 12, affecting operation performance of the photovoltaic solar cell string.

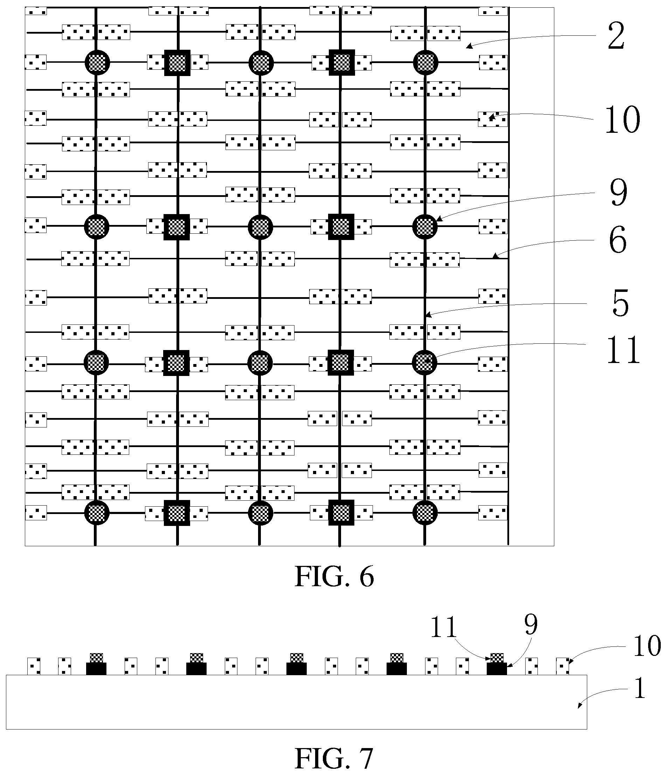

To resolve the foregoing technical problem, an embodiment of this application provides a photovoltaic solar cell structure. As shown in FIG. 6 and FIG. 7, the photovoltaic solar cell structure includes: a back contact solar cell 1, a soldering portion 9, an insulating material 10, and a conductive material 11. As shown in FIG. 6 and FIG. 7, each of the soldering portion 9 is at least located on a corresponding busbar 5 included in the back contact solar cell 1. The insulating material 10 covers at least a target part of each finger 6 included in the back contact solar cell 1. The target part is a part in which a distance between each of the finger 6 and a busbar 5 having a polarity opposite to that of the finger is less than a preset distance. The conductive material 11 is formed on each of the soldering portion 9, and a height of a top of the conductive material 11 is greater than or equal to a height of a top of the insulating material 10.

Specifically, the foregoing back contact solar cell may be any type of solar cell whose positive electrode and negative electrode are disposed on a back surface. A structure of the back contact solar cell in this embodiment of this application is not limited. For example, as shown in FIG. 3 to FIG. 5, the back contact solar cell 1 may include a solar cell body 2 and a positive electrode 3 and a negative electrode 4 formed on a back surface of the solar cell body 2. A specific structure of the solar cell body 2 may be set according to an actual requirement. For example, the solar cell body may include: a semiconductor substrate, a P-type doped semiconductor layer, and an N-type doped semiconductor layer. A material of the semiconductor substrate may include a semiconductor material such as silicon, silicon germanium, or gallium arsenide. The semiconductor substrate includes a first surface and a second surface opposite to the first surface. The second surface corresponds to the back surface of the solar cell body. The second surface includes a first region and a second region arranged alternately along the first direction along a direction parallel to the second surface. Length extending directions of the first region and second region are both parallel to the second direction. The P-type doped semiconductor layer is formed on or in the first region. The N-type doped semiconductor layer is formed on or in the second region. Doping concentrations of impurities in the P-type doped semiconductor layer and the N-type doped semiconductor layer may be set according to an actual application scenario, provided that the P-type doped semiconductor layer and the N-type doped semiconductor layer can be applied to the back contact solar cell provided in the embodiments of this application.

For the positive electrode and the negative electrode included in the back contact solar cell, the positive electrode and the negative electrode each may include at least one finger and at least one busbar. Fingers formed on the corresponding P-type doped semiconductor layer are fingers included in the positive electrode, which are configured to collect holes transmitted by the P-type doped semiconductor layer. In addition, busbars connected to the fingers included in the positive electrode are the busbars included in the positive electrode. On the contrary, fingers formed on the corresponding N-type doped semiconductor layer are the fingers included in the negative electrode, which are configured to collect electrons transmitted by the N-type doped semiconductor layer. In addition, busbars connected to the fingers included in the negative electrode are the busbars included in the negative electrode.

It may be understood that, a polarity of a finger included in the positive electrode is opposite to a polarity of a finger included in the negative electrode (or a busbar included in the negative electrode) and is the same as a polarity of another finger included in the positive electrode (or a busbar included in the positive electrode). Similarly, a polarity of a busbar included in the positive electrode is opposite to a polarity of a finger included in the negative electrode (or a busbar included in the negative electrode) and is the same as a polarity of another busbar included in the positive electrode (or a finger included in the positive electrode). Correspondingly, for electrodes whose polarities are respectively the same as or different from those of the finger and the busbar included in the negative electrode, reference may be made to the foregoing descriptions, and details are not described herein again.

In addition, the number of fingers and busbars included in the positive electrode and the negative electrode, a specific structure, and a distribution status are not specifically limited in the embodiments of this application. For example, the busbars included in the positive electrode and the busbars included in the negative electrode may extend along a first direction and are alternately spaced along a second direction. The first direction is different from the second direction. The fingers included in the positive electrode and the fingers included in the negative electrode extend along the second direction and are alternately spaced along the first direction. Each finger is connected to a busbar having the same polarity as that of the finger and is insulated from a busbar having a polarity opposite to that of the finger.

Each busbar included in the positive electrode and the negative electrode may be a straight line-shaped busbar, a wavy line-shaped busbar, or a curved line-shaped busbar. A specific shape of the busbar included in the positive electrode and the negative electrode may be set according to an actual application scenario, which is not specifically limited herein. In addition, each finger included in the positive electrode and the negative electrode may be a straight line-shaped finger, a wavy line-shaped finger, or a curved line-shaped finger, and a specific shape of the finger included in the positive electrode and the negative electrode may be set according to an actual application scenario, which is not specifically limited herein.

For the foregoing soldering portion, there may be one soldering portion or a plurality of soldering parts included in the photovoltaic solar cell structure. In addition, an arrangement position of each of the soldering portion on a corresponding busbar, a specification of each of the soldering portion, and a vertical distance between each of the soldering portion and the solar cell body may be set according to an actual application scenario, and are not specifically limited herein.

For example, as described above, when the busbar and the finger are located on the back surface of the solar cell body included in the back contact solar cell, the vertical distance between each of the soldering portion and the solar cell body may range from 1 mm to 15 mm. For example, the vertical distance between each of the soldering portion and the solar cell body may be 1 mm, 3 mm, 6 mm, 9 mm, 12 mm, or 15 mm. In this case, the vertical distance between each of the soldering portion and the solar cell body is moderate, to prevent the back contact solar cell from being greatly affected by a soldering stress because a vertical distance between the intra-string interconnection member and the solar cell body is small during soldering due to the small vertical distance, thereby ensuring that the back contact solar cell still has good structural stability and electrical operating performance after the photovoltaic solar cell string is formed. In addition, this can also prevent a long carrier transmission path caused by a large vertical distance between the intra-string interconnection member and the solar cell body after the photovoltaic solar cell string is formed through soldering because the vertical distance is large, thereby reducing a carrier transmission resistance, and further improving electrical performance of a photovoltaic module including the photovoltaic solar cell structure.

For the foregoing insulating material, a specific covering position of the insulating material on the back contact solar cell may be determined based on a distribution status of the fingers and the busbars included in the back contact solar cell and according to an actual requirement, provided that the covering position can be used in the photovoltaic solar cell structure provided in the embodiments of this application. In addition, a height of the insulating material may also be set according to an actual application scenario, which is not specifically limited herein. For example, the height of the insulating material may range from 10 µm to 80 µm. For example, the height of the insulating material may be 10 µm, 20 µm, 30 µm, 40 µm, 50 µm, 70 µm, or 80 µm. In the foregoing case, the height of the insulating material is moderate, so that it can be avoided that the insulating material has poor insulation performance because of a small height of the insulating material, and consequently, it is difficult to separate the intra-string interconnection member from a finger having a polarity opposite to that of the intra-string interconnection member by using the insulating material. In this way, high operation performance of the photovoltaic solar cell string including the photovoltaic solar cell structure is further ensured. In addition, it is also prevented that an amount of the insulating materials is increased because the height of the insulating material is large. In this way, manufacturing costs of the photovoltaic solar cell structure are reduced.

A type of the insulating material may be a material such as an insulating adhesive that has an isolating function.

For the foregoing conductive material, a forming range, a shape, and a transverse size of the conductive material on each of the soldering portion may be set according to an actual requirement, and are not specifically limited herein. For example, a shape of the conductive material formed on each of the soldering portion is a cube, an elliptic cylinder, or a cylinder. In this case, there are a plurality of optional solutions for the shape of the conductive material formed on each of the soldering portion. An appropriate shape of the conductive material formed on each of the soldering portion may be selected according to a requirement such as a cross-section shape of the soldering portion in an actual application scenario, to improve applicability of the photovoltaic solar cell structure provided in the embodiments of this application to different application scenarios.

A type of the foregoing conductive material may be any material that has a conduction function, provided that the material can be used in the photovoltaic solar cell structure provided in the embodiments of this application. For example, the conductive material may include at least one of a conductive adhesive, tin, and silver.

During actual application, as shown in FIG. 6 to FIG. 8, each of the soldering portion 9 is at least located on a corresponding busbar 5 included in the back contact solar cell 1, so that during a soldering process, the busbar 5 is connected to a corresponding intra-string interconnection member 12. In addition, the insulating material 10 included in the photovoltaic solar cell structure covers at least a target part of each finger 6 included in the back contact solar cell 1, and the target part is a part in which a distance between each of the finger 6 and a busbar 5 having a polarity opposite to that of the finger 6 is less than a preset distance. Based on this, because a polarity of the soldering portion 9 and the intra-string interconnection member 12 that are connected to each busbar 5 is the same as a polarity of the busbar 5, when the insulating material 10 covers at least a part of each finger 6 close to the busbar 5 having a polarity opposite to that of the finger 6, the intra-string interconnection member 12 can be prevented from overlapping with a finger 6 having a polarity opposite to that of the intra-string interconnection member 12 and forming a short-circuit during actual soldering due to offset of a placement position of the intra-string interconnection member 12, so that a requirement on precision of the placement position of the intra-string interconnection member 12 during soldering can be reduced, and difficulty in forming the photovoltaic solar cell string can be reduced. Secondly, a working environment of a photovoltaic solar cell structure is usually outdoors, and the outdoor environment is variable, which has an impact on structural stability of the photovoltaic solar cell structure. Based on this, the insulating material 10 is formed at least on the target position of the finger 6, and under protection of the insulating material 10, a risk that the finger 6 breaks can be effectively reduced, and the structural stability of the photovoltaic solar cell structure can be improved. It can be learned that, a size of the preset distance has an impact on precision of the placement position of the intra-string interconnection member 12 on the photovoltaic solar cell structure. It may be understood that, a larger preset distance indicates a smaller requirement on the precision of the placement position of the intra-string interconnection member 12 on the photovoltaic solar cell structure. A smaller preset distance indicates a higher requirement on the precision of the placement position of the intra-string interconnection member 12 on the photovoltaic solar cell structure. Therefore, the size of the preset distance may be determined based on actual manufacturing precision. This is not specifically limited herein.

For example, a range of the preset distance may be from 1.5 mm to 18 mm. For example, the preset distance may be 1.5 mm, 3 mm, 6 mm, 9 mm, 15 mm, or 18 mm. In the foregoing case, a size of the preset distance is moderate, to prevent a case in which a range in which the insulating material covers the finger is also small because the preset distance is small, and consequently, the placement position of the intra-string interconnection member needs to be strictly required, so that the intra-string interconnection member can be prevented from overlapping the finger having a polarity opposite to that of the intra-string interconnection member and forming a short-circuit. In this way, soldering difficulty is reduced. In addition, it is also prevented that the range in which the insulating material covers the finger is also large because the preset distance is large, and consequently, an amount of the insulating materials is increased. In this way, manufacturing costs of the photovoltaic solar cell structure are reduced.

Moreover, during actual application, as shown in FIG. 6 to FIG. 9, the conductive material 11 included in the photovoltaic solar cell structure is formed on each of the soldering portion 9, and a height of a top of the conductive material 11 is greater than or equal to a height of a top of the insulating material 10. In this case, the intra-string interconnection member 12 may be in contact with a corresponding soldering portion 9 through the conductive material 11, to prevent pseudo soldering, and ensure that all carriers generated during operation of each back contact solar cell 1 can be collected by a corresponding intra-string interconnection member 12, further ensuring high operation performance of the photovoltaic solar cell string including the photovoltaic solar cell structure. In addition, when the insulating material 10 is formed to enable the soldering portion 9 to be in contact with a corresponding intra-string interconnection member 12, a forming thickness of the insulating material 10 also does not need to be reduced to ensure that the insulating material 10 has insulation performance, so that it is ensured that the intra-string interconnection member 12 can be isolated from the finger 6 having a polarity opposite to that of the intra-string interconnection member 12 by using the insulating material 10, thereby improving high electrical stability of the photovoltaic solar cell string including the photovoltaic solar cell structure. It can be learned that, a height of a part of the conductive material 11 formed on each of the soldering portion 9 may be determined based on a difference between the height of the top of the soldering portion 9 and the height of the top of the insulating material 10, provided that it can be ensured that the height of the top of the conductive material 11 is greater than or equal to the height of the top of the insulating material 10. In addition, when the height of the top of the conductive material 11 is greater than the height of the top of the insulating material 10, a height difference between the two may be determined based on an actual application scenario, and this is not specifically limited herein.

It should be noted that, when the photovoltaic solar cell structure includes a plurality of soldering portions, shapes and sizes of conductive materials formed on different soldering portions may be the same, or may be different.

In a possible implementation, as shown in FIG. 6 and FIG. 7, when a shape of the conductive material 11 formed on each of the soldering portion 9 is a cube, a length of the cube ranges from 1 mm to 2 mm, a width of the cube ranges from 1 mm to 2 mm, and a height of the cube ranges from 0.1 mm to 1 mm. For example, the length of the cube may be 1 mm, 1.2 mm, 1.4 mm, 1.6 mm, 1.8 mm, or 2 mm; the width of the cube may be 1 mm, 1.2 mm, 1.4 mm, 1.6 mm, 1.8 mm, or 2 mm; and the height of the cube may be 0.1 mm, 0.3 mm, 0.5 mm, 0.7 mm, or 1 mm.

When the foregoing technical solution is used, when the shape of the conductive material formed on each of the soldering portion is the cube, the length, the width, and the height of the cube are all values in the corresponding ranges. Therefore, it is convenient to set, based on a difference between the height of the top of the insulating material and a height of a top of a corresponding soldering portion, a specification of the conductive material formed on each of the soldering portion, to ensure that the height of the top of the conductive material can be greater than or equal to the height of the top of the insulating material. In addition, the length, the width, and the height of the cube are all values in the corresponding ranges, to avoid strictly requiring manufacturing precision of a manufacturing device for forming the conductive material to form the cube of the fixed specification, and to reduce manufacturing difficulty of the photovoltaic solar cell structure and reduce investments in the manufacturing device.

During actual application, specific distribution statuses of the positive electrode and the negative electrode included in the back contact solar cell may be divided into at least the following three cases for description, based on whether the finger and the busbar included in the positive electrode and the negative electrode are respectively continuous (where a continuous electrode is an electrode on which no discontinuity exists) or discontinuous electrodes.

First case: As shown in FIG. 3, a positive electrode 3 and a negative electrode 4 included in the back contact solar cell 1 each include a plurality of busbars 5 and a plurality of fingers 6. The busbars 5 included in the positive electrode 3 and the busbars 5 included in the negative electrode 4 extend along a first direction and are alternately spaced along a second direction. The first direction is different from the second direction. The fingers 6 included in the positive electrode 3 and the fingers 6 included in the negative electrode 4 extend along the second direction and are alternately spaced along the first direction. Each of the fingers 6 is connected to a busbar 5 having the same polarity as that of the finger 6. Each of the fingers 6 includes a plurality of finger sections 7 distributed at intervals along the second direction, and a gap between two adjacent finger sections 7 in a same finger 6 is used for separating the finger 6 from a busbar 5 having a polarity opposite to that of the finger 6.

It may be understood that, in the first case, busbars included in the positive electrode and the negative electrode are all continuous electrodes, and fingers included in the positive electrode and the negative electrode are all discontinuous electrodes. A quantity of finger sections included in each finger, a gap between two adjacent finger sections, a position relationship between finger sections that are of a same section number and that are in different fingers having the same polarity, a position relationship between finger sections that are of a same section number and that are in different fingers having opposite polarities, and the like may be set based on an actual application scenario, and are not specifically limited herein.

For example, as shown in FIG. 3, a vertical distance between each of the finger sections 7 and an adjacent busbar 5 having a polarity opposite to that of the finger section 7 may be greater than 0 and less than or equal to 5 mm. For example, the vertical distance between each of the finger sections 7 and an adjacent busbar 5 having a polarity opposite to that of the finger section 7 may be 1 mm, 2 mm, 3 mm, 4 mm, or 5 mm. In the foregoing case, a value of the vertical distance is moderate, to prevent connection and a short-circuit between the busbar 5 and a finger section 7 having a polarity opposite to that of the busbar 5 because the vertical distance is small, thereby ensuring high electrical stability of the photovoltaic solar cell structure. In addition, a low carrier collection capability of each finger section 7 caused by a small length of the finger section 7 due to a large vertical distance can also be prevented, to ensure that carriers generated by the solar cell body 2 after absorbing photons can be collected by and exported from a corresponding finger section 7 in time, thereby improving photoelectric conversion efficiency of the photovoltaic solar cell structure.

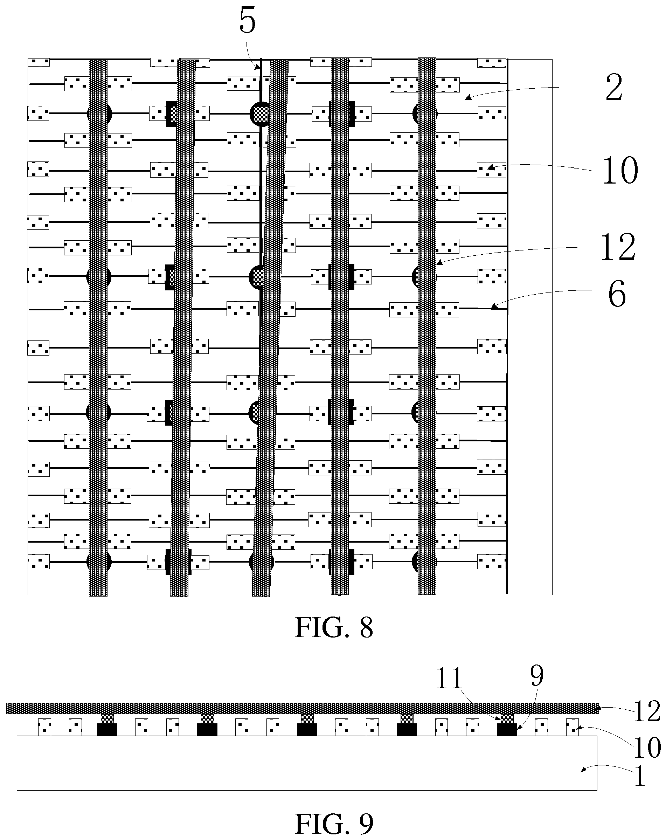

In addition, as shown in FIG. 6, in the first case, the insulating material 10 may cover two sides along the second direction of each of the busbar 5. In this case, as shown in FIG. 8, when a placement position of the intra-string interconnection member 12 is offset relative to a corresponding busbar 5 along the second direction, existence of the insulating material 10 can prevent the intra-string interconnection member 12 from overlapping with a finger section 7 having a polarity opposite to that of the intra-string interconnection member 12 and forming a short-circuit during actual soldering.

It is clear that the insulating material may alternatively cover a part of the busbar that is not connected to the soldering portion.

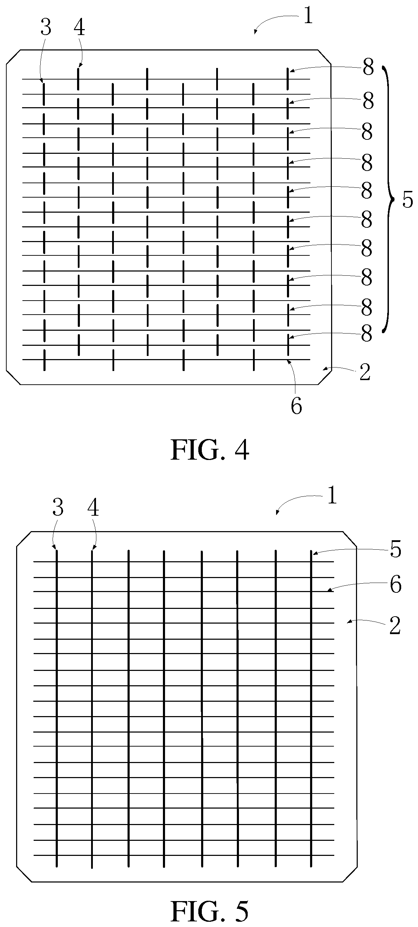

Second case: The following describes only places in which the second case is different from the first case. As shown in FIG. 4, in the second case, each busbar 5 is connected to a finger 6 having the same polarity as that of the busbar 5. Each busbar 5 includes a plurality of busbar sections 8 distributed at intervals along a first direction, and a gap between two adjacent busbar sections 8 in a same busbar 5 is used for separating the busbar 5 from a finger 6 having a polarity opposite to that of the busbar 5.

It may be understood that, in the second case, the busbars included in the positive electrode and the negative electrode are all discontinuous electrodes, and the fingers included in the positive electrode and the negative electrode are all continuous electrodes. A quantity of busbar sections included in each busbar, a gap between two adjacent busbar sections, a position relationship between busbar sections that are of a same section number and that are in different busbars having the same polarity, a position relationship between busbar sections that are of a same section number and that are in different busbars having opposite polarities, and the like may be set based on an actual application scenario, and are not specifically limited herein.

Third case: The following describes only places in which the third case is different from the first case. As shown in FIG. 5, in the third case, the busbars 5 and the fingers 6 included in the positive electrode 3 and the busbars 5 and the fingers 6 included in the negative electrode 4 are all continuous electrodes. Each busbar 5 may be isolated from a finger 6 having a polarity opposite to that of the busbar 5 through an insulating material.

It should be noted that, when the positive electrode and the negative electrode each include a plurality of fingers and a plurality of busbars, there may be a plurality of possible solutions only considering whether each finger is a continuous electrode or a discontinuous electrode and whether each busbar is a continuous electrode or a discontinuous electrode. This application only provides the foregoing three implementation solutions for example. Specific structures of the finger and the busbar are not the main feature of this application, and therefore, the specific structures of the finger and the busbar are only briefly described in this specification, so that a person of ordinary skill in the art can easily implement this application. It does not represent that the back contact solar cell included in the photovoltaic solar cell structure provided in the embodiments of this application can only have the foregoing three implementation solutions.

According to a second aspect, an embodiment of this application further provides a photovoltaic module. The photovoltaic module includes the photovoltaic solar cell structure according to the first aspect and various implementations of the first aspect, and an intra-string interconnection member configured to connect two adjacent photovoltaic solar cell structures. A distance between each part of each intra-string interconnection member and a corresponding busbar is greater than or equal to 0 and less than the preset distance. Specifically, a distance between each part of the intra-string interconnection member and the corresponding busbar may be determined in an actual manufacturing process, and is not specifically limited herein. For example, the distance between each part of each intra-string interconnection member and the corresponding busbar may be 0, 1.5 mm, 3 mm, 6 mm, 9 mm, 15 mm, or 17 mm.

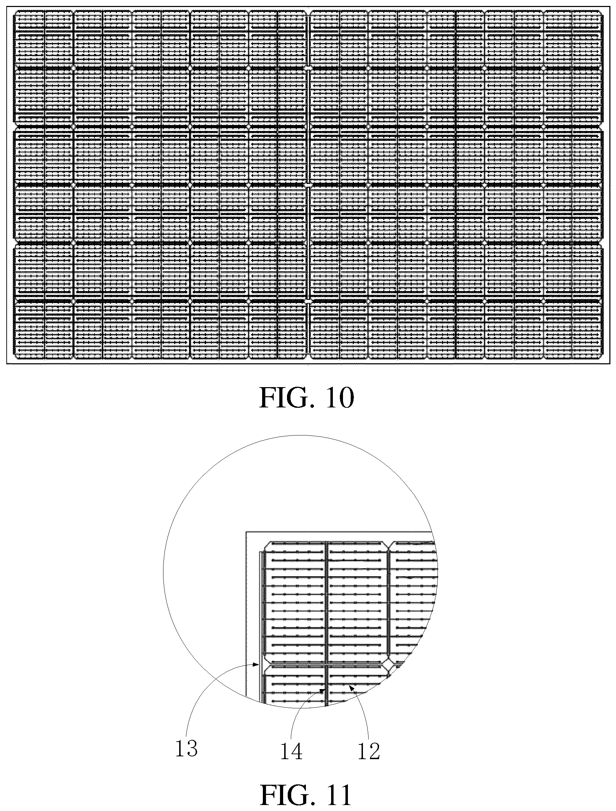

In a possible implementation, as shown in FIG. 8 to FIG. 10, the photovoltaic module includes a plurality of photovoltaic solar cell structures. The plurality of the photovoltaic solar cell structures are connected in series by using the intra-string interconnection member 12 to form at least two photovoltaic solar cell strings. As shown in FIG. 10 and FIG. 11, the photovoltaic module further includes a bus bar 13 and an insulating bar 14. The bus bar 13 is configured to connect the at least two photovoltaic solar cell strings in parallel. As shown in FIG. 11, the insulating bar 14 covers at least a gap between two adjacent photovoltaic solar cell structures, and/or the insulating bar 14 covers the bus bar 13.

A quantity of photovoltaic solar cell structures included in each photovoltaic solar cell string may be set according to an actual application scenario, and is not specifically limited herein. In addition, the insulating bar may cover only a gap between two adjacent photovoltaic solar cell structures. Alternatively, the insulating bar may cover only the bus bar. Alternatively, the insulating bar may cover a gap between two adjacent photovoltaic solar cell structures and the bus bar at the same time.

A material of the insulating bar may be an insulating material such as expandable polyethylene. A specification of the insulating bar may be set according to an actual requirement. For example, a thickness of the insulating bar may range from 0.05 mm to 0.3 mm. For example, the thickness of the insulating bar may be 0.05 mm, 0.1 mm, 0.15 mm, 0.2 mm, 0.25 mm, or 0.3 mm. For example, a width of the insulating bar may range from 1 mm to 3 mm. For example, the width of the insulating bar may be 1 mm, 1.5 mm, 2 mm, 2.5 mm, or 3 mm.

When the foregoing technical solution is used, when the insulating bar covers at least the gap between two adjacent photovoltaic solar cell structures, the insulating bar can prevent the two adjacent photovoltaic solar cell structures from overlapping, and can also block the intra-string interconnection member between the two adjacent photovoltaic solar cell structures, thereby reducing a risk such as breaking or overlapping of the intra-string interconnection member, and improving structural stability and electrical performance of the photovoltaic module. In addition, when the insulating bar covers the bus bar, a risk that the bus bar brakes can also be reduced, and the entire photovoltaic module can be beautiful.

According to a third aspect, an embodiment of this application further provides a manufacturing method of a photovoltaic solar cell structure. The manufacturing method of a photovoltaic solar cell structure includes: providing a back contact solar cell;
forming a soldering portion on at least a corresponding busbar solar cell included in the back contact solar cell;
forming an insulating material covering at least a target part of each finger included in the back contact solar cell; where the target part is a part in which a distance between each of the finger and a busbar having a polarity opposite to that of the finger is less than a preset distance; and
forming a conductive material on each of the soldering portion, where a height of a top of the conductive material is greater than or equal to a height of a top of the insulating material.

Specifically, the soldering portion, the insulating material, and the conductive material may be formed in steps by using a process such as screen printing. A sequence of forming the soldering portion and the insulating material is not limited. In addition, a sequence of forming the insulating material and the conductive material is not limited.

For example, the soldering portion may be first formed, then the insulating material is formed, and finally the conductive material is formed.

For another example, the soldering portion may be first formed, then the conductive material is formed, and finally the insulating material is formed.

For still another example, the insulating material may be first formed, then the soldering portion is formed, and finally the conductive material is formed.

For beneficial effects of the second aspect and various implementations of the second aspect and the third aspect and various implementations of the third aspect in the embodiments of this application, reference may be made to the analysis of the beneficial effects of the first aspect and various implementations of the first aspect, and details are not described herein again.

In the foregoing descriptions, technical details such as composition and etching of each layer are not described in detail. However, a person skilled in the art should understand that a layer, a region, and the like of a required shape may be formed through various technical means. In addition, to form the same structure, a person skilled in the art may further design a method that is not exactly the same as the method described above. In addition, although the embodiments are separately described above, this does not mean that the measures in the embodiments cannot be advantageously used in combination.

"An embodiment", "embodiment", or "more or more embodiments" mentioned in the specification means that particular features, structures, or characteristics described with reference to the embodiment or embodiments may be included in at least one embodiment of this application. In addition, it should be noted that the wording example "in an embodiment" herein does not necessarily indicate a same embodiment.

In this specification provided herein, numerous specific details are described. However, it should be understood that the embodiments of this application may be practiced without such specific details. In some examples, well-known methods, structures, and technologies are not shown in detail so as not to obscure the understanding of the specification.

Finally, it should be noted that, the foregoing embodiments are merely intended for describing the technical solutions of this application, but not for limiting this application. Although this application is described in detail with reference to the foregoing embodiments, a person of ordinary skill in the art is to understand that modifications may still be made to the technical solutions described in the foregoing embodiments or equivalent replacements may be made to some technical features thereof, provided that such modifications or replacements do not cause the essence of corresponding technical solutions to depart from the spirit and scope of the technical solutions of the embodiments of this application.

## Claims

1. A photovoltaic solar cell structure, comprising: a back contact solar cell, a soldering portion, an insulating material, and a conductive material, wherein
each of the soldering portion is at least located on a corresponding busbar comprised in the back contact solar cell;
the insulating material covers at least a target part of each finger comprised in the back contact solar cell; and the target part is a part in which a distance between each of the finger and a busbar having a polarity opposite to that of the finger is less than a preset distance; and
the conductive material is formed on each of the soldering portion, and a height of a top of the conductive material is greater than or equal to a height of a top of the insulating material.

2. The photovoltaic solar cell structure according to claim 1, wherein a range of the preset distance is from 1.5 mm to 18 mm; and/or
a height of the insulating material ranges from 10 µm to 80 µm.

3. The photovoltaic solar cell structure according to claim 1, wherein a shape of the conductive material formed on each of the soldering portion is a cube, an elliptic cylinder, or a cylinder.

4. The photovoltaic solar cell structure according to claim 1, wherein a shape of the conductive material formed on each of the soldering portion is a cube; and a length of the cube ranges from 1 mm to 2 mm, a width of the cube ranges from 1 mm to 2 mm, and a height of the cube ranges from 0.1 mm to 1 mm.

5. The photovoltaic solar cell structure according to any one of claims 1 to 4, wherein a positive electrode and a negative electrode comprised in the back contact solar cell each comprise a plurality of busbars and a plurality of fingers, wherein
the busbars comprised in the positive electrode and the busbars comprised in the negative electrode extend along a first direction and are alternately spaced along a second direction; and the first direction is different from the second direction; and
the fingers comprised in the positive electrode and the fingers comprised in the negative electrode extend along the second direction and are alternately spaced along the first direction; each of the fingers is connected to a busbar having the same polarity as that of the finger; and each of the fingers comprises a plurality of finger sections distributed at intervals along the second direction, and a gap between two adjacent finger sections in a same finger is used for separating the finger from a busbar having a polarity opposite to that of the finger.

6. The photovoltaic solar cell structure according to claim 5, wherein the insulating material covers two sides along the second direction of each of the busbar.

7. The photovoltaic solar cell structure according to claim 5, wherein a vertical distance between each of the finger sections and an adjacent busbar having a polarity opposite to that of the finger section is greater than 0 and less than or equal to 5 mm.

8. The photovoltaic solar cell structure according to any one of claims 1 to 4, wherein the busbars and the fingers are located on a back surface of a solar cell body comprised in the back contact solar cell; and
a vertical distance between each of the soldering portion and the solar cell body ranges from 1 mm to 15 mm.

9. The photovoltaic solar cell structure according to any one of claims 1 to 4, wherein the insulating material is an insulating adhesive; and/or the conductive material comprises at least one of a conductive adhesive, tin, and silver.

10. A photovoltaic module, comprising the photovoltaic solar cell structure according to any one of claims 1 to 9, and an intra-string interconnection member configured to connect two adjacent photovoltaic solar cell structures, wherein
a distance between each part of each intra-string interconnection member and a corresponding busbar is greater than or equal to 0 and less than the preset distance.

11. The photovoltaic module according to claim 10, wherein the photovoltaic module comprises a plurality of the photovoltaic solar cell structures; and the plurality of the photovoltaic solar cell structures are connected in series by using the intra-string interconnection member to form at least two photovoltaic solar cell strings; and
the photovoltaic module further comprises a bus bar and an insulating bar; the bus bar is configured to connect the at least two photovoltaic solar cell strings in parallel; and the insulating bar covers at least a gap between two adjacent photovoltaic solar cell structures, and/or the insulating bar covers the bus bar.

12. A manufacturing method of a photovoltaic solar cell structure, comprising:
providing a back contact solar cell;
forming a soldering portion on at least a corresponding busbar comprised in the back contact solar cell;
forming an insulating material covering at least a target part of each finger comprised in the back contact solar cell; wherein the target part is a part in which a distance between each of the finger and a busbar having a polarity opposite to that of the finger is less than a preset distance; and
forming a conductive material on each of the soldering portion, wherein a height of a top of the conductive material is greater than or equal to a height of a top of the insulating material.
